# FASCICULE DE BREVET EUROPEEN

(11) **EP 4 576 170 B1**
(45) Date de publication et mention de la délivrance du brevet: **08.07.2026**
(21) Numéro de dépôt: 24222054.9
(22) Date de dépôt: 20.12.2024
(51) Int. Cl.: H10D 30/01, H10D 64/01, H10D 30/67, H10D 64/66, H10D 30/60

(54) **TRANSISTOR MOS À FAIBLE COURANT DE FUITE**
MOS-TRANSISTOR MIT NIEDRIGEM LECKSTROM
MOS TRANSISTOR WITH LOW LEAKAGE CURRENT

(30) Priorité: 22.12.2023 FR 2315149
(43) Date de publication de la demande: 25.06.2025
(73) Titulaire: Commissariat à l'Energie Atomique et aux Energies Alternatives, 75015 Paris (FR)
(72) Inventeur: BRUNET, Laurent, 38054 Grenoble Cedex 09 (FR); LACORD, Joris, 38054 Grenoble Cedex 09 (FR)
(74) Mandataire: Cabinet Camus Lebkiri

(56) Documents cités:
- US-A1- 2008 308 870
- US-B2- 7 666 727

## Description

### DOMAINE TECHNIQUE DE L'INVENTION

Le domaine technique de l'invention est celui des transistors à effet de champ métal-oxyde-semi-conducteur ou MOSFET (acronyme de « metal oxyde semiconductor field effect transistor »), et notamment ceux fabriqués à partir d'un substrat comprenant une couche isolante enterrée, typiquement un substrat de type silicium sur isolant (ou SOI, pour « silicon on insulator » en anglais). La présente invention concerne plus particulièrement un transistor à effet de champ comprenant une structure de grille configurée pour diminuer le courant de fuite du drain induit par la grille, ou courant GIDL (pour « gate induced drain leakage » en anglais).

### ARRIERE-PLAN TECHNOLOGIQUE DE L'INVENTION

Un substrat silicium sur isolant ou SOI (pour « Silicon On Insulator » en anglais) comprend successivement une couche de support en silicium, une couche électriquement isolante dite enterrée, généralement une couche d'oxyde (ou couche BOX, pour « buried oxide layer » en anglais), et un film mince en silicium monocristallin, aussi appelé couche active. La couche active est ainsi nommée car elle est destinée à recevoir des composants actifs, typiquement des transistors à effet de champ métal-oxyde-semi-conducteur ou MOSFET (acronyme de « metal oxyde semiconductor field effect transistor »). Le canal de conduction des MOSFET est formé dans la couche active. Le substrat SOI offre notamment la possibilité de fabriquer des transistors SOI complètement déplétés (ou FDSOI, pour « Fully Depleted SOI ») ou partiellement déplétés (ou PDSOI « Partially Depleted SOI »).

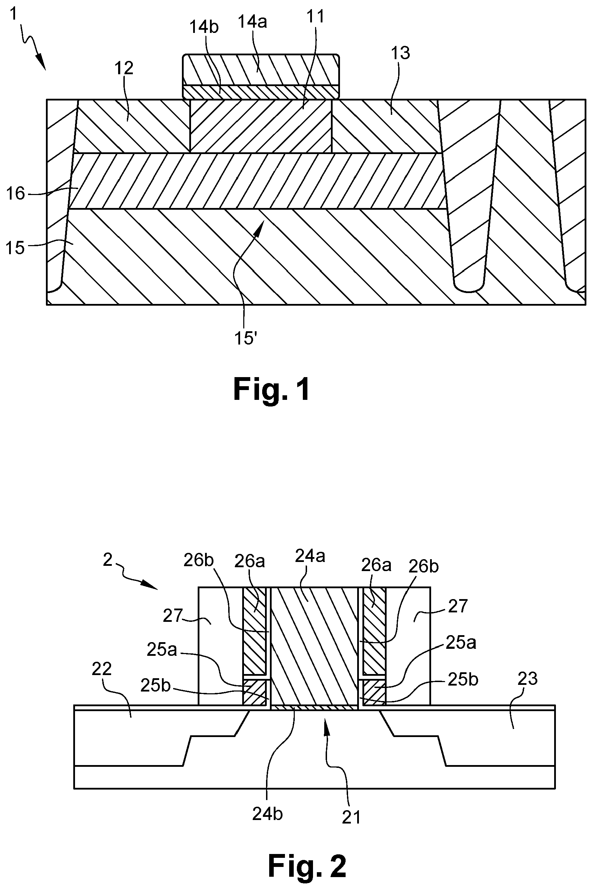

La figure 1 est une vue en coupe schématique d'un transistor SOI 1. Le transistor SOI 1 comprend une région de canal 11, une région de source 12 et une région de drain 13, toutes les trois formées dans le film mince de silicium du substrat SOI. La région de canal 11 est disposée entre la région de source 12 et la région de drain 13. Le film mince de silicium est surmonté d'une électrode de grille 14a, disposée en regard de la région de canal 11. L'électrode de grille 14a est séparée de la région de canal 11 par une couche diélectrique de grille 14b.

Le transistor SOI 1 comprend en outre une région de silicium dopé 15 appelée caisson (« well »), dont une partie 15' appelée plan de masse (« ground plane ») ou grille arrière (« back gate ») est située sous la couche électriquement isolante 16 du substrat SOI.

La grille arrière 15' agit comme une seconde grille. En faisant varier le potentiel électrique de la grille arrière 15', séparée de la région de canal 11 par la couche électriquement isolante 16, il est possible de moduler (dynamiquement) la tension de seuil transistor SOI 1 et par conséquent sa résistance à l'état passant (R_{ON}).

Le transistor SOI 1 peut être un transistor à canal n, aussi appelé transistor nFET, ou à canal p, aussi appelé transistor pFET. Dans un transistor nFET, les régions de source et de drain 12-13 sont dopées de type n et la région de canal 11 est dopée de type p. A l'inverse, dans un transistor pFET, les régions de source et de drain 12-13 sont dopées de type p et la région de canal 11 est dopée de type n.

Comme la plupart des MOSFET formés sur un substrat en silicium massif (« bulk »), le transistor SOI 1 souffre à l'état bloqué d'un courant de fuite appelé courant de fuite du drain induit par la grille ou courant GIDL (pour « gate induced drain leakage » en anglais).

Le courant GIDL résulte de la génération de paires électron-trou dans une zone de déplétion qui se forme à la surface de la région de drain 13, là où l'électrode de grille 14a chevauche la région de drain 13. Il se manifeste pour des valeurs de tension grille-source V_{GS} négatives dans le cas d'un nFET et positives dans le cas d'un pFET.

La figure 2 représente un transistor à effet de champ 2 conçu pour présenter un faible courant GIDL et décrit dans la demande de brevet US2004/137689A1. Ce transistor à effet de champ 2, de type nFET, comprend :
- une région de canal 21, une région de source 22, une région de drain 23, toutes les trois formées dans un substrat massif ;
- une structure de grille comprenant :
   - une électrode de grille 24a dite « centrale » en silicium polycristallin dopé de type p ;
   - une couche diélectrique de grille 24b séparant l'électrode de grille 24a de la région de canal 21 ;
   - des extensions de grille latérales 25a en silicium polycristallin dopé de type n, disposées contre des flancs de l'électrode de grille 24a ;
   - une couche barrière électriquement isolante 25b en oxyde de silicium séparant les extensions de grille latérales 25a du substrat et de l'électrode de grille 24a ;
   - des espaceurs métalliques 26a en tungstène ou nitrure de tungstène disposés sur les extensions de grille latérales 25a ; et
   - une couche barrière électriquement conductrice 26b séparant les espaceurs métalliques 26a de l'électrode de grille 24a et des extensions de grille latérales 25a ; et
- des espaceurs isolants 27 disposés contre des flancs de la structure de grille.

L'épaisseur de la couche barrière électriquement isolante 25b (en oxyde de silicium) est supérieure à l'épaisseur de la couche diélectrique de grille 24b.

Le transistor à effet de champ 2 présente cependant d'importantes capacités parasites et offre un moins contrôle des effets de canal court. En particulier, l'effet d'abaissement de la barrière de potentiel par le drain ou effet DIBL (pour « drain-induced barrier lowering » en anglais) est accentué. Par ailleurs, la fabrication du transistor requiert un très grand nombre d'étapes technologiques.

Les documents US2008/308870 et US7666727 décrivent d'autres exemples de transistors à effet de champ.

### RESUME DE L'INVENTION

Il existe donc un besoin de prévoir un transistor à effet de champ qui présente de meilleures performances électriques et qui puisse être fabriqué plus simplement.

Un aspect de l'invention concerne un procédé de fabrication d'un transistor à effet de champ comprenant une région de source, une région de drain et une région de canal disposée entre les régions de source et de drain, ce procédé comprenant les étapes suivantes :
- former un empilement de grille sur une couche semi-conductrice, l'empilement de grille comprenant une couche diélectrique de grille disposée sur la couche semi-conductrice et une électrode de grille séparée de la couche semi-conductrice par la couche diélectrique de grille, l'électrode de grille étant formée d'un matériau semi-conducteur dopé présentant un premier travail de sortie, l'électrode de grille présentant un premier flanc destiné à être du côté de la région de source et un deuxième flanc destiné à être du côté de la région de drain ;
- former une couche sacrificielle recouvrant au moins le deuxième flanc de l'électrode de grille ;
- former un espaceur contre au moins le deuxième flanc de l'électrode de grille, l'espaceur étant séparé de l'électrode de grille par la couche sacrificielle ;
- graver partiellement la couche sacrificielle de manière à exposer une partie du deuxième flanc de l'électrode de grille ;
- déposer une couche de métal au moins sur la partie exposée du deuxième flanc de l'électrode de grille ;
- effectuer un recuit de manière à faire réagir le métal avec le matériau semi-conducteur dopé de l'électrode de grille et transformer une portion de l'électrode de grille en un conducteur de grille latéral s'étendant jusqu'à la couche diélectrique de grille en contact direct avec une portion restante de l'électrode de grille, le métal étant choisi de sorte que le conducteur de grille latéral soit formé d'un deuxième matériau conducteur présentant un deuxième travail de sortie, le deuxième travail de sortie étant :
   - strictement supérieur au premier travail de sortie dans le cas d'un transistor de type p ;
   - strictement inférieur au premier travail de sortie dans le cas d'un transistor de type n.

Dans un mode de mise en œuvre préférentiel, la couche sacrificielle est déposée sur la couche semi-conductrice, les flancs de l'électrode de grille et une face supérieure de l'électrode de grille, l'espaceur étant en outre séparé de la couche semi-conductrice par la couche sacrificielle.

Selon un développement de ce mode de mise en œuvre préférentiel, l'étape de gravure partielle de la couche sacrificielle comprend avantageusement les opérations suivantes :
- graver une portion supérieure de la couche sacrificielle disposée sur la face supérieure de l'électrode de grille ;
- effectuer une sur-gravure de la couche sacrificielle, de sorte à graver une portion de la couche sacrificielle située entre l'électrode de grille et l'espaceur.

Avantageusement, le procédé comprend en outre, avant l'étape de dépôt de la couche de métal, une étape de nettoyage d'une surface exposée de la couche semi-conductrice, d'une face supérieure de l'électrode de grille et de la partie exposée du deuxième flanc de l'électrode de grille, l'étape de nettoyage étant accomplie de sorte à poursuivre la gravure de la couche sacrificielle entre l'électrode de grille et l'espaceur.

Avantageusement, la couche de métal est en outre déposée sur une face supérieure de l'électrode de grille et sur des régions exposées de la couche semi-conductrice situées de part et d'autre de l'empilement de grille et de l'espaceur.

Le conducteur de grille latéral diminue le champ électrique vertical au moins près de la région de drain lorsque le transistor est polarisé à des valeurs de tension grille-source V_{GS} négatives dans le cas d'un nFET et positives dans le cas d'un pFET, et donc la génération de paires électron-trou par effet tunnel bande à bande à l'origine du courant GIDL. Le contact direct entre le conducteur de grille latéral et l'électrode de grille évite l'apparition de nouvelles capacités parasites, assure un bon contrôle des effets de canaux courts tels que l'effet DIBL et simplifie la fabrication du transistor.

Dans un mode de réalisation préférentiel, le transistor comprend en outre une couche électriquement isolante, sur laquelle sont disposées la région de canal et les régions de source et de drain.

Selon un développement de ce mode de réalisation préférentiel, le transistor comprend en outre une grille arrière séparée de la région de canal par la couche électriquement isolante.

Outre les caractéristiques qui viennent d'être évoquées dans les paragraphes précédents, le transistor peut présenter une ou plusieurs caractéristiques complémentaires parmi les suivantes, considérées individuellement ou selon toutes les combinaisons techniquement possibles :
- le deuxième matériau conducteur est un composé de matériau semi-conducteur et d'un ou plusieurs éléments métalliques, de préférence un siliciure ;
- la structure de grille chevauche les régions de source et de drain ;
- le conducteur de grille latéral est disposé tout autour de l'électrode de grille ;
- le transistor comprend en outre un espaceur disposé contre au moins un flanc de la structure de grille et séparé de la structure de grille par une couche de matériau diélectrique ;
- la couche diélectrique de grille est d'épaisseur constante ;
- le conducteur de grille latéral s'étend sur toute la hauteur de l'électrode de grille ;
- le deuxième travail de sortie est :
   - supérieur ou égal à 110 % du premier travail de sortie lorsque le transistor est de type p ; et
   - inférieur ou égal à 90 % du premier travail de sortie lorsque le transistor est de type n.

### BREVE DESCRIPTION DES FIGURES

D'autres caractéristiques et avantages de l'invention ressortiront clairement de la description qui en est donnée ci-dessous, à titre indicatif et nullement limitatif, en référence aux figures annexées, parmi lesquelles :
- la figure 1 représente schématiquement un transistor SOI selon l'art antérieur ;
- la figure 2 représente schématiquement un transistor à effet de champ sur substrat silicium massif selon l'art antérieur ;
- la figure 3 représente schématiquement un mode de réalisation préférentiel d'un transistor à effet de champ selon le premier aspect de l'invention, le transistor comprenant des conducteurs de grille latéraux ;
- la figure 4 représente, en fonction de la tension grille-source V_{GS}, le courant de drain I_{D} d'un transistor de type pFET pour plusieurs valeurs du travail de sortie W₂ des conducteurs de grille latéraux ;
- la figure 5 représente, en fonction de la tension grille-source V_{GS}, le courant de drain I_{D} d'un transistor de type nFET pour plusieurs valeurs du travail de sortie W₂ des conducteurs de grille latéraux ; et
- les figures 6A à 6G illustrent un mode de mise en œuvre préférentiel du procédé de fabrication de transistor à effet de champ selon le deuxième aspect de l'invention.

Pour plus de clarté, les éléments identiques ou similaires sont repérés par des signes de référence identiques sur l'ensemble des figures.

### DESCRIPTION DETAILLEE

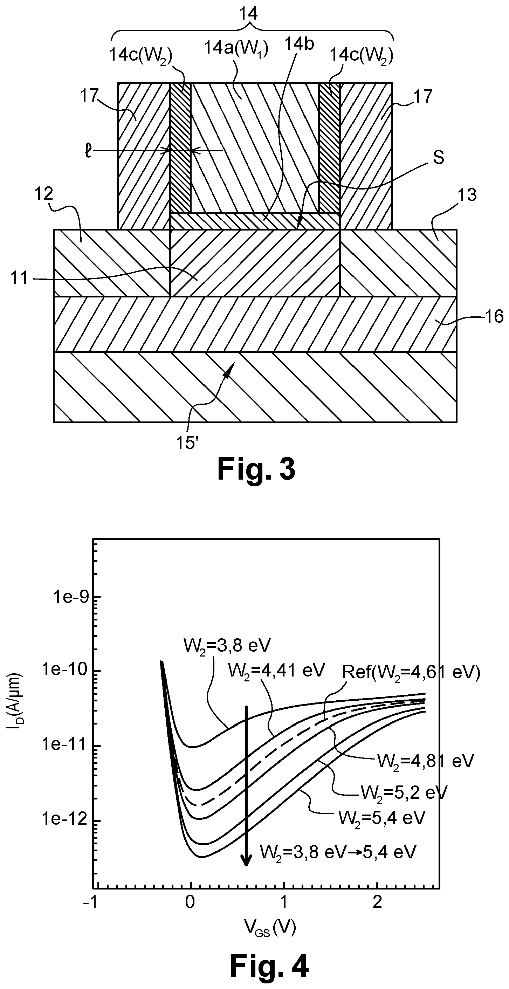

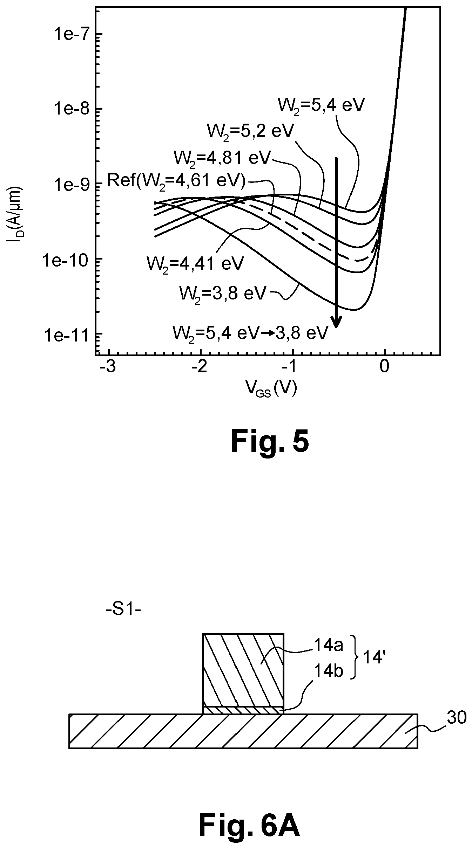

Dans la description qui suit, les termes « avant », « arrière », « supérieur », « inférieur », « dessus », « dessous », « horizontal », « vertical », « latéral », etc. utilisés pour qualifier la position ou l'orientation de certains éléments font référence à l'orientation des figures 3 et 6A à 6G. Par ailleurs, sauf précision contraire, les expressions « approximativement », « sensiblement » et « de l'ordre de » signifient à 10 % près.

La figure 3 est une vue en coupe schématique d'un transistor à effet de champ (FET) 3 selon un mode de réalisation préférentiel de l'invention.

A l'instar du transistor 1 illustré par la figure 1, le transistor à effet de champ 3 (désigné ci-après le transistor 3) comprend :
- une région de canal 11 ;
- une région de source 12 et une région de drain 13 disposées de part et d'autre de la région de canal 11 ;
- une structure de grille 14 disposée sur la région de canal 11 ;
- une couche électriquement isolante 16 sur laquelle sont disposées la région de canal 11, la région de source 12 et la région de drain 13.

Le transistor 3 est dans ce mode de réalisation préférentiel fabriqué à partir d'une structure multicouche comprenant successivement une couche de support, une couche isolante dite enterrée et une couche active.

La couche de support est de préférence en un matériau semi-conducteur, par exemple en silicium.

La couche isolante enterrée est de préférence une couche d'oxyde enterrée (ou couche BOX, pour « buried oxide layer » en anglais), par exemple en dioxyde de silicium (SiO₂). Son épaisseur est par exemple comprise entre 5 nm et 145 nm.

La couche active (aussi appelée couche mince, couche de dispositif ou couche supérieure) est en un matériau semi-conducteur, par exemple en silicium, germanium ou alliage de silicium-germanium. Son épaisseur est par exemple comprise entre 3 nm et 100 nm.

La structure multicouche peut notamment être un substrat de type silicium sur isolant (ou SOI, pour « Silicon On Insulator » en anglais). Le transistor 3 est alors qualifié de transistor SOI.

La région de canal 11, la région de source 12 et la région de drain 13 sont formées dans la couche active de la structure multicouche. Elles reposent sur la couche isolante 16 (qui correspond à la couche isolante enterrée de la structure multicouche). Ces régions appartiennent à la zone active du transistor, qui peut être délimitée latéralement par des tranchées d'isolation électrique (non représentées sur la figure 3, mais visibles sur la figure 1). Les tranchées d'isolation électrique s'étendent à travers la couche active, la couche isolante enterrée et une partie de la couche de support de la structure multicouche. La structure de grille 14 est disposée sur la couche active.

La région de canal 11 peut s'étendre, dans une direction perpendiculaire à une surface S de la structure multicouche, de la structure de grille 14 jusqu'à la couche isolante 16 et, dans un plan parallèle à cette même surface S, de la région de source 12 à la région de drain 13. Ainsi, la région de canal 11 peut présenter une épaisseur égale à celle de la couche active. Les régions de source et de drain 12-13 peuvent également occuper la couche active dans toute son épaisseur, comme cela est illustré sur la figure 3.

Les régions de source et de drain 12-13 sont dopées de type n dans le cas d'un transistor à effet de champ de type n (nFET) et de type p dans le cas d'un transistor à effet de champ de type p (pFET). Chacun des régions de source et de drain 12-13 comprend une région fortement dopée, c'est-à-dire une région dont la concentration en impuretés dopantes (de type donneur dans un nFET et de type accepteur dans un pFET) est supérieure ou égale à 10¹⁸ cm⁻³, par exemple égale à 10²⁰ cm⁻³.

Chacun des régions de source et de drain 12-13 peut comprendre une outre une région faiblement dopée, communément appelée extension LDD (pour « low doped drain » en anglais), située entre la région de canal 11 et la région fortement dopée. La concentration en impuretés dopantes des extensions LDD est strictement inférieure à la concentration en impuretés dopantes des régions fortement dopées. Elle est par exemple égale à 10¹⁹ cm⁻³ lorsque la concentration en impuretés dopantes des régions fortement dopées est égale à 10²⁰ cm⁻³.

La structure de grille 14 comprend une électrode de grille 14a et une couche diélectrique de grille 14b séparant l'électrode de grille 14a de la région de canal 11. Le transistor 3 est donc un MOSFET. L'électrode de grille 14a est formée d'un premier matériau électriquement conducteur présentant un premier travail de sortie W₁. Ce premier matériau conducteur peut être un matériau métallique comme le nitrure de titane (TiN) ou le tungstène (W), ou du silicium polycristallin dopé (assimilé à un métal au sens de l'appellation MOS). La couche diélectrique de grille 14b peut être en dioxyde de silicium (SiO₂) ou en un matériau diélectrique présentant une constante diélectrique plus élevée que celle du dioxyde de silicium (matériau dit « high-k »). Elle peut également comprendre plusieurs sous-couches formées de matériaux diélectriques différents.

Une particularité du transistor 3 est que la structure de grille 14 comprend en outre un conducteur de grille latéral 14c disposé contre au moins un des flancs (ou surfaces latérales) de l'électrode de grille 14a. Ce conducteur de grille latéral 14c, aussi appelé extension de grille latérale, s'étend de préférence sur toute la hauteur de l'électrode de grille 14a. Il est formé d'un deuxième matériau électriquement conducteur présentant un deuxième travail de sortie W₂ différent du premier travail de sortie W₁. Le flanc contre lequel repose le conducteur de grille latéral 14c est situé du côté de la région de drain 13.

Le conducteur de grille latéral 14c est de préférence de forme annulaire et disposé autour de l'électrode de grille 14a. Il est alors disposé contre tous les flancs de l'électrode de grille 14a. Alternativement, la structure de grille 14 peut comprendre deux conducteurs de grille latéraux 14c distincts disposés contre les deux flancs opposés de l'électrode de grille 14a situés du côté de la région de source 12 et du côté de la région de drain 13.

Le deuxième matériau conducteur (et donc le deuxième travail de sortie W₂) est choisi de sorte à diminuer le champ électrique vertical à proximité d'au moins la région de drain 13, et de préférence à proximité des régions de source et de drain 12-13, lorsque le transistor 3 est polarisé à des valeurs de tension grille-source V_{GS} négatives dans le cas d'un nFET et positives dans le cas d'un pFET. Ainsi, la génération de paires électron-trou par effet tunnel bande à bande, qui est à l'origine du courant GIDL, est diminuée.

La structure de grille 14 comprenant le conducteur de grille latéral (ou les conducteurs de grille latéraux) 14c peut chevaucher les régions de source et de drain 12-13, c'est-à-dire les recouvrir en partie. L'effet de diminution du courant GIDL est alors particulièrement fort.

Le deuxième matériau conducteur est de préférence un composé de matériau semi-conducteur et d'un ou plusieurs éléments métalliques, tel qu'un siliciure (composé de silicium et d'un ou plusieurs éléments métalliques). Alternativement, le deuxième matériau conducteur peut être un matériau métallique (c'est-à-dire comprenant un ou plusieurs métaux) ou du silicium polycristallin dopé.

Les figures 4 et 5 montrent des résultats de simulation numérique de deux exemples de transistor 3 selon la figure 3, respectivement un pFET et un nFET. Pour chaque transistor, seul le deuxième travail de sortie W₂ du conducteur de grille latéral 14c varie entre les différentes simulations numériques. Le premier travail de sortie W₁ de l'électrode de grille 14a est invariable et, dans ces simulations, égal à 4,61 eV (valeur typique d'un métal de grille « midgap » comme le TiN et le W). La simulation de référence notée « Ref », dans laquelle le deuxième travail de sortie W₂ est égal au premier travail de sortie W₁ (W₂ = W₁ = 4,61 eV), correspond à un transistor comprenant un conducteur de grille latéral formé du même matériau que l'électrode de grille 14a (soit l'équivalent d'un transistor selon la figure 1 comprenant uniquement l'électrode de grille 14a).

La figure 4 représente l'évolution du courant de drain I_{D} du pFET en fonction de la tension grille-source V_{GS} pour différentes valeurs du deuxième travail de sortie W₂ (allant de 3,8 eV à 5,4 eV).

Cette figure montre que le courant de drain I_{D} à une tension V_{GS} positive (autrement dit le courant de drain du pFET dans l'état bloqué) diminue lorsque le deuxième travail de sortie W₂ augmente et qu'il devient inférieur à celui du transistor de référence (courbe « Ref ») lorsque le deuxième travail de sortie W₂ dépasse la valeur du premier travail de sortie W₁.

En d'autres termes, lorsque le transistor 3 est de type pFET, un deuxième travail de sortie W₂ strictement supérieur au premier travail de sortie W₁ permet de diminuer le courant GIDL.

A titre d'exemple, lorsque le premier matériau conducteur (électrode de grille 14a) est choisi parmi le nitrure de titane (TiN) (W₁ ≈ 4,6 eV), le tungstène (W) (W₁ ≈ 4,7 eV) et le silicium polycristallin dopé n (W₁ ≈ 4,0 eV), le deuxième matériau conducteur est avantageusement choisi parmi les siliciures de nickel (4,6 eV ≤ W₂ ≤ 4,8 eV) et les siliciures de platine (5,16 eV ≤ W₂ ≤ 5,25 eV).

De façon analogue, la figure 5 représente l'évolution du courant de drain I_{D} du nFET en fonction de la tension grille-source V_{GS} pour différentes valeurs du deuxième travail de sortie W₂ (allant de 3,8 eV à 5,4 eV).

Cette figure montre que le courant de drain I_{D} à une tension V_{GS} négative (autrement dit le courant de drain du nFET dans l'état bloqué) diminue lorsque le deuxième travail de sortie W₂ diminue et qu'il devient inférieur à celui du transistor de référence (courbe « Ref ») lorsque le deuxième travail de sortie W₂ devient strictement inférieur au premier travail de sortie W₁.

Ainsi, lorsque le transistor 3 est de type nFET, un deuxième travail de sortie W₂ strictement inférieur au premier travail de sortie W₁ permet de diminuer le courant GIDL.

A titre d'exemple, lorsque le premier matériau conducteur (électrode de grille 14a) est choisi parmi le nitrure de titane (TiN) (W₁ ≈ 4,6 eV), le tungstène (W) (W₁ ≈ 4,7 eV) et le silicium polycristallin dopé p (W₁ ≈ 5,2 eV), le deuxième matériau conducteur est avantageusement choisi parmi les siliciures de titane (par exemple, W₂ ≈ 4,0 eV pour TiSi₂) et les siliciures de tantale (ex. W₂ ≈ 4,2 eV pour TaSi₂).

Afin d'obtenir une diminution significative du courant GIDL, le deuxième travail de sortie W₂ est avantageusement :
- supérieur ou égal à 110 % du premier travail de sortie W₁ lorsque le transistor est de type pFET ; et
- inférieur ou égal à 90 % du premier travail de sortie W₁ lorsque le transistor est de type nFET.

Comme illustré sur la figure 3, le conducteur de grille latéral 14c s'étend jusqu'à la couche diélectrique de grille 14b, en contact direct avec l'électrode de grille 14a. Autrement dit, il n'y a donc pas de couche intermédiaire (comme couche barrière électriquement isolante 25b dans le transistor 2 de la figure 2) entre le conducteur de grille latéral 14c et l'électrode de grille 14a. Les capacités parasites et les autres figures de mérite du transistor 3, telles que le courant de fuite dû à l'effet DIBL, ne sont donc pas affectées.

Le conducteur de grille latéral 14c présente une section de largeur l qui peut être comprise entre 1 nm et 30 nm, par exemple égale à 10 nm ou 20 nm. La largeur l du conducteur de grille latéral14c est mesurée parallèlement à la surface S de la structure multicouche dans le plan de coupe de la figure 3 (autrement dit selon la même direction que la distance entre les régions de source et de drain 12-13). D'autres simulations numériques ont montré que la largeur l du conducteur de grille latéral14c avait un impact négligeable sur la caractéristique courant-tension I_{D}-V_{GS} du transistor 3, et donc sur le courant GIDL.

Sous l'électrode de grille 14a et le conducteur de grille latéral 14c, la couche diélectrique de grille 14b présente avantageusement une épaisseur constante, d'un flanc à l'autre de la structure de grille 14 (ou de la région de source 12 à la région de drain 13). L'épaisseur de la couche diélectrique de grille 14b est par exemple comprise entre 2 nm et 20 nm.

Le transistor 3 peut également comprendre une grille arrière 15' séparée de la région de canal 11 par la couche isolante 16. La grille arrière 15', aussi appelée plan de masse (« ground plane »), est située sous la couche isolante 16, en regard de la région de canal 11. Elle agit comme une seconde grille. En faisant varier le potentiel électrique de la grille arrière 15', il est possible de moduler (dynamiquement) la tension de seuil du transistor 3 et par conséquent sa résistance à l'état passant (R_{ON}).

La grille arrière 15' est formée d'un matériau semi-conducteur dopé. Elle appartient de préférence à une région semi-conductrice dopée appelée caisson (« well »), s'étendant au-delà de la zone active du transistor 3 (donc au-delà des tranchées d'isolation électrique ; cf. Fig.1).

Ce caisson peut être formé en implantant des impuretés dopantes dans la couche de support de la structure multicouche. Le caisson peut être dopé de type n ou de type p. La grille arrière 15' peut présenter une concentration en impuretés dopantes plus élevée que la partie restante du caisson.

Enfin, le transistor 3 peut comprendre un espaceur 17 disposé contre un ou plusieurs flancs de la structure de grille 14, et de préférence tout autour de la structure de grille 14. Cet espaceur 17 peut être en contact direct avec la couche diélectrique de grille 14b et le conducteur de grille latéral 14c, et de préférence, en contact direct avec les régions de source et de drain 12-13. Il est formé d'un matériau diélectrique tel que le nitrure de silicium (SiN). Alternativement, il peut être séparé de du conducteur de grille latéral 14c et des régions de source et de drain 12-13 par une couche de matériau diélectrique.

Dans une variante de réalisation non représentée par les figures, le transistor 3 est fabriqué à partir d'un substrat semi-conducteur massif, par exemple en silicium, germanium ou alliage de silicium-germanium. Le transistor 3 diffère alors de celui représenté par la figure 3 essentiellement en ce qu'il est dépourvu de couche isolante 16 et de grille arrière 15'. La région de canal 11, la région de source 12 et la région de drain 13 sont formées dans le substrat semi-conducteur massif.

Le courant GIDL d'un transistor MOSFET sur substrat massif est également diminué par l'utilisation du conducteur de grille latéral 14c ayant un travail de sortie (W₂) différent de celui de l'électrode de grille 14a.

Un mode de mise en œuvre préférentiel d'un procédé de fabrication du transistor 3 va maintenant être décrit en référence aux figures 6A à 6G. Ces figures représentent, en vue de coupe, différentes étapes S1-S7 du procédé de fabrication du transistor 3.

La première étape S1, représentée par la figure 6A, consiste à former un empilement de grille 14' sur une couche semi-conductrice 30, par exemple en silicium. La couche semi-conductrice 30 peut être soit la couche active d'une structure multicouche (typiquement un substrat SOI), soit un substrat semi-conducteur massif. L'empilement de grille 14' comprend l'électrode de grille 14a et la couche diélectrique de grille 14b. L'électrode de grille 14a est ici en un matériau semi-conducteur dopé, tel que le silicium polycristallin dopé. La couche diélectrique de grille 14b est par exemple en dioxyde de silicium (SiO₂) ou en oxynitrure de silicium (SiON).

La formation de l'empilement de grille 14' peut notamment comprendre le dépôt d'une couche diélectrique sur la couche semi-conductrice 30, le dépôt d'une couche de matériau semi-conducteur dopé sur la couche diélectrique, la gravure de la couche de matériau semi-conducteur dopé pour délimiter l'électrode de grille 14a et, de préférence, la gravure de la couche diélectrique à travers l'électrode de grille 14a pour délimiter la couche diélectrique de grille 14b. Ces opérations étant classiques, elles ne seront pas décrites plus en détail ici.

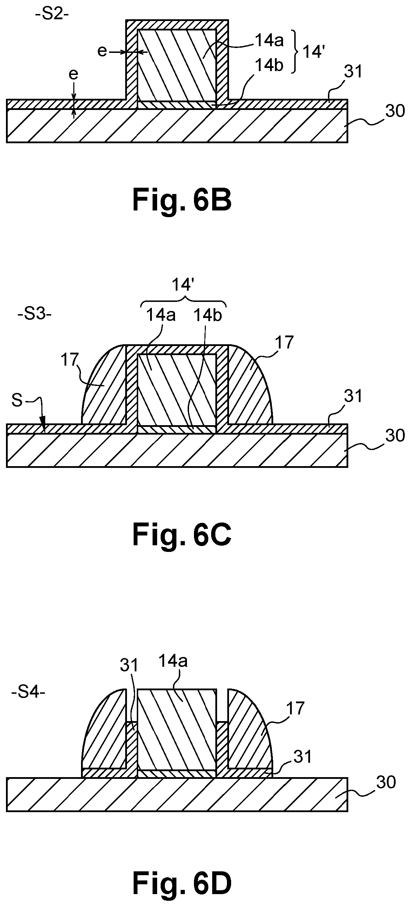

Puis, à l'étape S2 de la figure 6B, une couche sacrificielle 31, de préférence en un matériau diélectrique tel que le SiO₂, est formée au moins sur des flancs de l'électrode de grille 14a. Cette couche sacrificielle 31 présente une épaisseur e qui est de préférence comprise entre 5 nm et 15 nm.

Comme cela est illustré sur la figure 6B, la couche sacrificielle 31 est préférentiellement déposée sur la couche semi-conductrice 30 (en dehors de l'empilement de grille 14'), les flancs (ou surfaces latérales) de l'électrode de grille 14a et une face supérieure de l'électrode de grille 14a. Ainsi, la couche sacrificielle 31 recouvre totalement l'empilement de grille 14'. Le dépôt est avantageusement conforme, c'est-à-dire que l'épaisseur e de la couche sacrificielle 31 (mesurée perpendiculairement à la surface sur laquelle est repose) est sensiblement constante.

En S3 (cf. Fig.6C), l'espaceur 17 du transistor 3 est formé autour de l'électrode de grille 14a. L'espaceur 17 n'est pas en contact direct avec l'électrode de grille 14a, mais séparé de l'électrode de grille 14a par la couche sacrificielle 31. L'espaceur 17 est de préférence en un matériau diélectrique, par exemple en nitrure de silicium (SiN). Le matériau diélectrique de l'espaceur 17 est différent de celui de la couche sacrificielle 31. Sa formation peut comprendre :
- une sous-étape de dépôt conforme d'une couche diélectrique sur la couche semi-conductrice 30 (en dehors de l'empilement de grille 14'), les flancs de l'électrode de grille 14a et la face supérieure de l'électrode de grille 14a ; et
- une sous-étape de gravure anisotrope de la couche diélectrique, selon une direction préférentielle de gravure perpendiculaire à la surface S de la couche semi-conductrice 30, afin de graver les parties horizontales de la couche diélectrique (situées sur la couche semi-conductrice 30 et la face supérieure de l'électrode de grille 14a) et conserver ses parties verticales (adossées contre les flancs de l'électrode de grille 14a).

Lorsque la couche sacrificielle 31 a été déposée sur la couche semi-conductrice 30, l'espaceur 17 est en outre séparé de la couche semi-conductrice 30 par la couche sacrificielle 31 (cf. Fig.6C).

La gravure anisotrope est avantageusement sélective par rapport à la couche sacrificielle 31 (la couche sacrificielle 31 sert donc de couche d'arrêt de la gravure).

Lors de l'étape S4 représentée par la figure 6D, la couche sacrificielle 31 est gravée partiellement de manière à exposer une partie des flancs de l'électrode de grille 14a.

Cette étape S4 de gravure peut comprendre deux opérations successives : une première opération de gravure de la portion supérieure de la couche sacrificielle 31, avec arrêt sur la face supérieure de l'électrode de grille 14a, et une deuxième opération sur-gravure de la couche sacrificielle 31, pour graver une portion située entre l'électrode de grille 14a et l'espaceur 17. La portion de la couche sacrificielle 31 disposée sur la couche semi-conductrice 30 et non recouverte par l'espaceur 17 est gravée en même temps que la portion supérieure, lors de la première opération.

A titre d'exemple, la couche sacrificielle 31 est gravée de manière anisotrope au moyen d'un plasma fluorocarboné, puis par gravure humide dans un bain d'acide fluorhydrique (HF), avec une surgravure inférieure ou égale à 30 %. La couche sacrificielle 31 peut être également gravée uniquement par gravure plasma.

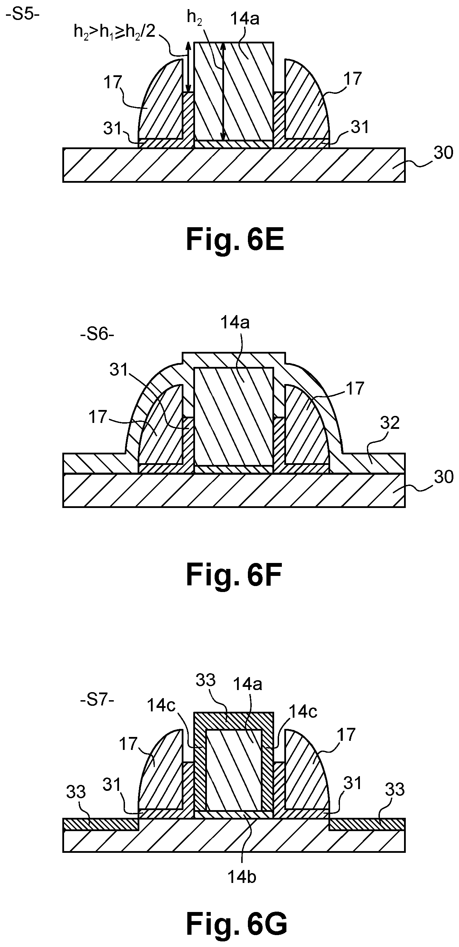

En référence à la figure 6E, le procédé de fabrication peut comprendre ensuite une étape de nettoyage de la surface exposée de la couche semi-conductrice 30 (ou surface dite « libre », c'est-à-dire non recouverte par l'empilement de grille 14', la couche sacrificielle 31 et l'espaceur 17), de la face supérieure de l'électrode de grille 14a et de la partie exposée des flancs de l'électrode de grille 14a. Cette étape de nettoyage, optionnelle, est avantageusement accomplie de sorte à poursuivre la gravure de la couche sacrificielle 31 entre l'électrode de grille 14a et l'espaceur 17.

Un tel nettoyage est particulièrement utile lorsque l'électrode de grille 14a est en silicium polycristallin. Il permet de poursuivre la gravure de la couche sacrificielle 31 tout en limitant la consommation de l'électrode de grille 14a (et de la couche semi-conductrice 30, le cas échéant). Le nettoyage présente alors une sélectivité de gravure (de la couche sacrificielle 31 vis-à-vis de l'électrode de grille 14a) supérieure à la gravure de l'étape S4 qui le précède.

Le nettoyage permet en outre d'éliminer les impuretés ou contaminants en surface de la couche semi-conductrice 30 et de l'électrode de grille 14a, en prévision des étapes ultérieures du procédé.

Le nettoyage peut être accompli par voie humide (par exemple au moyen d'une solution d'acide fluorhydrique dans le cas d'une couche sacrificielle 31 en SiO₂) ou par voie sèche (par exemple au moyen du procédé Siconi^{™} dans le cas d'une couche sacrificielle 31 en SiO₂).

Les étapes suivantes S6 et S7 des figures 6F et 6G sont relatives à la formation du conducteur de grille latéral 14c du transistor 3. Le conducteur de grille latéral 14c est, dans ce mode de mise en œuvre du procédé de fabrication, formé d'un composé de matériau semi-conducteur et d'un ou plusieurs éléments métalliques, et plus particulièrement d'un siliciure dans le cas d'une grille en silicium polycristallin. Les étapes S6 et S7 peuvent donc être qualifiées d'étapes de siliciuration.

En S6 (cf. Fig.6F), une couche de métal 32 est déposée au moins sur la partie exposée des flancs de l'électrode de grille 14, et avantageusement, sur la face supérieure de l'électrode de grille 14a et la surface exposée de la couche semi-conductrice 30. La couche de métal 32 est par exemple en titane, tantale, platine, nickel, cobalt ou en un alliage de plusieurs de ces métaux. Son épaisseur est par exemple comprise entre 5 nm et 15 nm.

Enfin, en S7 (cf. Fig.6G), un recuit est accompli de manière à faire réagir le métal avec (au moins) le matériau semi-conducteur dopé de l'électrode de grille 14a et transformer (au moins) une portion (ici périphérique) de l'électrode de grille 14a en conducteur de grille latéral 14c. Le conducteur de grille latéral 14c s'étend jusqu'à la couche diélectrique de grille 14b, en contact direct avec une portion restante (centrale) de l'électrode de grille 14a. La portion résiduelle de la couche sacrificielle 31 empêche la réaction du métal avec la couche semi-conductrice 30 entre l'espaceur 17 et l'électrode de grille 14a.

Le métal de la couche de métal 32 est choisi de sorte que le composé métal-semi-conducteur du conducteur de grille latéral 14c présente un travail de sortie W₂ différent du travail de sortie W₁ de l'électrode de grille 14a (strictement supérieur ou strictement inférieur au travail de sortie W₁ selon le type de transistor, respectivement pFET ou nFET).

Après l'étape S4 de gravure partielle de la couche sacrificielle 31, et l'étape de nettoyage S5 le cas échéant, la partie exposée des flancs de l'électrode de grille 14a s'étend sur une hauteur h₁ telle que le conducteur de grille latérale 14c obtenu à l'issue de l'étape S7 s'étend jusqu'à la couche diélectrique de grille 14b (cf. Figs.6E-6G). Selon un exemple de réalisation, on peut prévoir que la hauteur h₁ de la partie exposée des flancs de l'électrode de grille 14a est supérieure ou égale à la moitié de la hauteur h₂ de l'électrode de grille 14a et strictement inférieure à la hauteur h₂ de l'électrode de grille 14a (h₂ > h₁ ≥ h₂/2). Cet exemple de réalisation dépend bien entendu des conditions expérimentales mais aussi des matériaux mis en œuvre (espèces, dépôt, recuit, durée, températures... etc). Tout changement intervenant sur une des conditions expérimentales ou sur l'un des matériaux impliquera nécessairement des changements sur les hauteurs à prévoir pour faire en sorte que le conducteur de grille latérale 14c obtenu à l'issue de l'étape S7 s'étend jusqu'à la couche diélectrique de grille 14b.

Lorsque la couche de métal 32 a en outre été déposée en contact direct avec la face supérieure de l'électrode de grille 14a et des régions de la couche semi-conductrice 30, de part et d'autre de l'empilement de grille 14' et de l'espaceur 17, des zones électriquement conductrices 33 sont obtenues en même temps que le conducteur de grille latéral 14c, respectivement pour la prise de contact électrique de l'électrode de grille 14a et des régions de source et de drain 12-13.

Une portion de la couche de métal 32 peut ne pas avoir réagi lors du recuit (tel est notamment le cas de la portion de la couche de métal 32 disposée sur l'espaceur 17, dans le cas d'un dépôt « pleine plaque »). Cette portion restante de la couche de métal 32 est alors retirée après le recuit.

Le procédé de fabrication comprend par ailleurs une étape de formation des région de source et de drain 12-13 dans deux régions distinctes de la couche semi-conductrice 30, de préférence par implantation (ionique) d'impuretés dopantes, la portion restante (non implantée) de de la couche semi-conductrice 30 formant alors la région de canal 11 du transistor 3 (cette étape permet donc aussi de délimiter la région de canal 11).

Cette étape de formation des région de source et de drain 12-13 est accomplie après l'étape S3 de formation de l'espaceur 17, de préférence avant l'étape S4 de gravure de la couche sacrificielle 31 (l'implantation des ions s'effectuant donc à travers la couche sacrificielle).

Le procédé de fabrication peut également comprendre, dans le cas d'une structure multicouche, une étape de formation d'une grille arrière 15' sous la couche isolante enterrée 16, de préférence par implantation d'impuretés dopantes (des ions) dans la couche de support de la structure multicouche. Cette étape de formation de la grille arrière 15' est accomplie avant l'étape S1 de formation de l'empilement de grille 14'.

Ces autres étapes de fabrication étant classiques, elles ne seront pas décrites plus en détail.

Le procédé de fabrication décrit ci-dessus en relation avec les figures 6A-6G est particulièrement simple à mettre en œuvre et comprend moins d'étapes technologiques que le procédé de fabrication du transistor 2 de la figure 2. Il permet en outre la formation simultanée du conducteur de grille latéral 14c et des zones de prise de contact 33, pour l'électrode de grille 14a et les régions de source et de drain 12-13. La portion restante de la couche sacrificielle 31, lorsqu'elle est formée d'un matériau diélectrique comme le SiO₂, contribue à diminuer les capacités parasites du transistor 3.

De nombreuses variantes et modifications du procédé de fabrication apparaitront à l'homme du métier. En particulier, la couche sacrificielle 31 et l'espaceur 17 peuvent être formés que contre une partie des flancs de l'électrode de grille, et notamment contre un seul flanc, celui destiné à être du côté de la région de drain (d'où il résulte que le conducteur de grille latéral 14c est disposé contre ce seul flanc).

## Revendications

1. Procédé de fabrication d'un transistor à effet de champ (3) comprenant une région de source (12), une région de drain (13) et une région de canal (11) disposée entre les régions de source (12) et de drain (13), le procédé comprenant les étapes suivantes :
- former un empilement de grille (14') sur une couche semi-conductrice (30), l'empilement de grille comprenant une couche diélectrique de grille (14b) disposée sur la couche semi-conductrice (30) et une électrode de grille (14a) séparée de la couche semi-conductrice (30) par la couche diélectrique de grille (14b), l'électrode de grille (14a) étant formée d'un matériau semi-conducteur dopé présentant un premier travail de sortie (W₁), l'électrode de grille (14a) présentant un premier flanc destiné à être du côté de la région de source (12) et un deuxième flanc destiné à être du côté de la région de drain (13) ;
- former une couche sacrificielle (31) recouvrant au moins le deuxième flanc de l'électrode de grille (14a) ;
- former un espaceur (17) contre au moins le deuxième flanc de l'électrode de grille (14a), l'espaceur (17) étant séparé de l'électrode de grille (14a) par la couche sacrificielle (31) ;
- graver partiellement la couche sacrificielle (31) de manière à exposer une partie du deuxième flanc de l'électrode de grille (14a) ;
- déposer une couche de métal (32) au moins sur la partie exposée du deuxième flanc de l'électrode de grille (14a) ;
- effectuer un recuit de manière à faire réagir le métal avec le matériau semi-conducteur dopé de l'électrode de grille (14a) et transformer une portion de l'électrode de grille en un conducteur de grille latéral (14c) s'étendant jusqu'à la couche diélectrique de grille (14b) en contact direct avec une portion restante de l'électrode de grille (14a), le métal étant choisi de sorte que le conducteur de grille latéral (14c) soit formé d'un deuxième matériau conducteur présentant un deuxième travail de sortie (W₂), le deuxième travail de sortie (W₂) étant :
∘ strictement supérieur au premier travail de sortie (W₁) dans le cas d'un transistor de type p ;
∘ strictement inférieur au premier travail de sortie (W₁) dans le cas d'un transistor de type n.

2. Procédé selon la revendication 1, dans lequel la couche sacrificielle (31) est déposée sur la couche semi-conductrice (30), les flancs de l'électrode de grille (14a) et une face supérieure de l'électrode de grille, l'espaceur (17) étant en outre séparé de la couche semi-conductrice (30) par la couche sacrificielle (31).

3. Procédé selon la revendication 2, dans lequel l'étape de gravure partielle de la couche sacrificielle (31) comprend les opérations suivantes :
- graver une portion supérieure de la couche sacrificielle (31) disposée sur la face supérieure de l'électrode de grille (14a) ;
- effectuer une sur-gravure de la couche sacrificielle (31), de sorte à graver une portion de la couche sacrificielle située entre l'électrode de grille (14a) et l'espaceur (17).

4. Procédé selon l'une quelconque des revendications 1 à 3, comprenant en outre, avant l'étape de dépôt de la couche de métal (32), une étape de nettoyage d'une surface exposée de la couche semi-conductrice (30), d'une face supérieure de l'électrode de grille (14a) et de la partie exposée du deuxième flanc de l'électrode de grille, l'étape de nettoyage étant accomplie de sorte à poursuivre la gravure de la couche sacrificielle (31) entre l'électrode de grille (14a) et l'espaceur (17).

5. Procédé selon l'une quelconque des revendications 1 à 4, dans lequel la couche de métal (32) est en outre déposée sur une face supérieure de l'électrode de grille (14a) et sur des régions exposées de la couche semi-conductrice (30) situées de part et d'autre de l'empilement de grille (14') et de l'espaceur (17).

## Patentansprüche

1. Verfahren zur Herstellung eines Feldeffekttransistors (3) mit einem Source-Bereich (12), einem Drain-Bereich (13) und einem zwischen dem Source-Bereich (12) und dem Drain-Bereich (13) angeordneten Kanalbereich (11), wobei das Verfahren die folgenden Schritte umfasst:
- Bilden eines Gate-Stapels (14') auf einer Halbleiterschicht (30), wobei der Gate-Stapel eine auf der Halbleiterschicht (30) angeordnete dielektrische Gate-Schicht (14b) und eine durch die dielektrische Gate-Schicht (14b) von der Halbleiterschicht (30) getrennte Gate-Elektrode (14a) umfasst, wobei die Gate-Elektrode (14a) aus einem dotierten Halbleitermaterial mit einer ersten Austrittsarbeit (W₁) gebildet ist und eine erste Flanke, die zur Seite des Source-Bereichs (12) zeigen soll, und eine zweite Flanke, die zur Seite des Drain-Bereichs (13) zeigen soll, aufweist;
- Bilden einer Opferschicht (31), die zumindest die zweite Flanke der Gate-Elektrode (14a) bedeckt;
- Bilden eines Abstandshalters (17) an mindestens der zweiten Flanke der Gate-Elektrode (14a), wobei der Abstandshalter (17) durch die Opferschicht (31) von der Gate-Elektrode (14a) getrennt ist;
- teilweises Ätzen der Opferschicht (31), um einen Teil der zweiten Flanke der Gate-Elektrode (14a) freizulegen;
- Aufbringen einer Metallschicht (32) zumindest auf den freiliegenden Teil der zweiten Flanke der Gitterelektrode (14a);
- Durchführen eines Tempervorgangs, um das Metall mit dem dotierten Halbleitermaterial der Gate-Elektrode (14a) reagieren zu lassen und einen Teil der Gate-Elektrode in einen seitlichen Gate-Leiter (14c) umzuwandeln, der sich bis zur dielektrischen Gate-Schicht (14b) erstreckt und in direktem Kontakt mit einem verbleibenden Teil der Gate-Elektrode (14a) steht, wobei das Metall so gewählt ist, dass der seitliche Gate-Leiter (14c) aus einem zweiten leitfähigen Material mit einer zweiten Austrittsarbeit (W₂ ) gebildet wird, wobei die zweite Austrittsarbeit (W₂)
o im Fall eines p-Typ-Transistors streng größer als die erste Austrittsarbeit (W₁) ist;
o im Fall eines n-Typ-Transistors streng kleiner als die erste Austrittsarbeit (W₁) ist.

2. Verfahren nach Anspruch 1, bei dem die Opferschicht (31) auf der Halbleiterschicht (30), den Flanken der Gate-Elektrode (14a) und einer Oberseite der Gate-Elektrode aufgetragen wird, wobei der Abstandshalter (17) ferner durch die Opferschicht (31) von der Halbleiterschicht (30) getrennt ist.

3. Verfahren nach Anspruch 2, bei dem der Schritt des teilweisen Ätzens der Opferschicht (31) die folgenden Vorgänge umfasst:
- Ätzen eines oberen Abschnitts der Opferschicht (31), die auf der Oberseite der Gate-Elektrode (14a) angeordnet ist;
- Durchführen eines Überätzens der Opferschicht (31), um einen Abschnitt der Opferschicht zwischen der Gate-Elektrode (14a) und dem Abstandshalter (17) zu ätzen.

4. Verfahren nach einem der Ansprüche 1 bis 3, das ferner vor dem Schritt des Aufbringens der Metallschicht (32) einen Schritt zum Reinigen einer freiliegenden Oberfläche der Halbleiterschicht (30), einer Oberseite der Gate-Elektrode (14a) und des freiliegenden Teils der zweiten Flanke der Gate-Elektrode umfasst, wobei der Reinigungsschritt so durchgeführt wird, dass das Ätzen der Opferschicht (31) zwischen der Gate-Elektrode (14a) und dem Abstandshalter (17) fortgesetzt wird.

5. Verfahren nach einem der Ansprüche 1 bis 4, bei dem die Metallschicht (32) ferner auf einer Oberseite der Gate-Elektrode (14a) und auf freiliegenden Bereichen der Halbleiterschicht (30) aufgebracht wird, die sich auf beiden Seiten des Gate-Stapels (14') und des Abstandshalters (17) befinden.

## Claims

1. A method for manufacturing a field effect transistor (3) comprising a source region (12), a drain region (13) and a channel region (11) disposed between the source (12) and drain (13) regions, the method comprising the following steps of:
- forming a gate stack (14') on a semiconducting layer (30), the gate stack comprising a gate dielectric layer (14b) disposed on the semiconducting layer (30) and a gate electrode (14a) separated from the semiconducting layer (30) by the gate dielectric layer (14b), the gate electrode (14a) being formed of a doped semiconductor material having a first work function (W₁), the gate electrode (14a) having a first flank to be on the side of the source region (12) and a second flank to be on the side of the drain region (13);
- forming a sacrificial layer (31) covering at least the second flank of the gate electrode (14a);
- forming a spacer (17) against at least the second flank of the gate electrode (14a), the spacer (17) being separated from the gate electrode (14a) by the sacrificial layer (31);
- partially etching the sacrificial layer (31) so as to expose a part of the second flank of the gate electrode (14a);
- depositing a metal layer (32) at least onto the exposed part of the second flank of the gate electrode (14a);
- performing annealing so as to react the metal with the doped semiconductor material of the gate electrode (14a) and transform a portion of the gate electrode into a lateral gate conductor (14c) extending to the gate dielectric layer (14b) in direct contact with a remaining portion of the gate electrode (14a), the metal being selected such that the lateral gate conductor (14c) is formed of a second conductive material having a second work function (W₂), the second work function (W₂) being:
∘ strictly greater than the first work function (W₁) in the case of a p-type transistor;
∘ strictly lower than the first work function (W₁) in the case of an n-type transistor.

2. The method according to claim 1, wherein the sacrificial layer (31) is deposited onto the semiconducting layer (30), the flanks of the gate electrode (14a) and an upper face of the gate electrode, the spacer (17) being further separated from the semiconducting layer (30) by the sacrificial layer (31).

3. The method according to claim 2, wherein the step of partially etching the sacrificial layer (31) comprises the following operations of:
- etching an upper portion of the sacrificial layer (31) disposed on the upper face of the gate electrode (14a);
- performing over-etching of the sacrificial layer (31) so as to etch a portion of the sacrificial layer located between the gate electrode (14a) and the spacer (17).

4. The method according to any of claims 1 to 3, further comprising, before the step of depositing the metal layer (32), a step of cleaning an exposed surface of the semiconducting layer (30), an upper face of the gate electrode (14a) and the exposed part of the second flank of the gate electrode, the cleaning step being carried out so as to continue etching the sacrificial layer (31) between the gate electrode (14a) and the spacer (17).

5. The method according to any of claims 1 to 4, wherein the metal layer (32) is further deposited onto an upper face of the gate electrode (14a) and onto exposed regions of the semiconducting layer (30) located on either side of the gate stack (14') and the spacer (17).
